(19) **Europäisches Patentamt / European Patent Office / Office européen des brevets**

(11) **EP 4 529 028 B1**

(12) **FASCICULE DE BREVET EUROPEEN**

(45) Date de publication et mention
de la délivrance du brevet:
**24.12.2025 Bulletin 2025/52**

(21) Numéro de dépôt: **24198987.0**

(22) Date de dépôt: **06.09.2024**

(51) Classification Internationale des Brevets (IPC):
**H04B 5/40** *(2024.01)* **H04L 27/06** *(2006.01)*
**H04L 7/00** *(2006.01)*

(52) Classification Coopérative des Brevets (CPC):
**H04B 5/40; H04L 7/0079; H04L 27/06;**
H04L 7/0008

(54) **DISPOSITIF DE COMMUNICATION SANS CONTACT PAR MODULATION ACTIVE DE CHARGE DOTÉ D'UN CIRCUIT D'EXTRACTION DE SIGNAL D'HORLOGE À SEUIL DYNAMIQUE**

KONTAKTLOSE LASTMODULATIONSKOMMUNIKATIONSVORRICHTUNG MIT DYNAMISCHER SCHWELLWERT-TAKTSIGNALEXTRAKTIONSSCHALTUNG

ACTIVE LOAD MODULATION CONTACTLESS COMMUNICATION DEVICE WITH DYNAMIC THRESHOLD CLOCK SIGNAL EXTRACTION CIRCUIT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **19.09.2023 FR 2309886**

(43) Date de publication de la demande:
**26.03.2025 Bulletin 2025/13**

(73) Titulaire: **STMicroelectronics International N.V.**
**1228 Plan-les-Ouates, Geneva (CH)**

(72) Inventeurs:
• **BARTHELEMY, Florent**
**38000 GRENOBLE (FR)**
• **HOUDEBINE, Marc**
**38920 CROLLES (FR)**
• **GARCIA, Laurent Jean**
**38190 LE CHAMP PRES FROGES (FR)**

(74) Mandataire: **Cabinet Beaumont**
**4, Place Robert Schuman**
**B.P. 1529**
**38025 Grenoble Cedex 1 (FR)**

(56) Documents cités:
**EP-A1- 1 986 136 US-A1- 2014 159 870**

• **CHOKE TIENG YING ET AL: "A 3.4Mbps NFC card emulator supporting 40mm2 loop antenna", 2017 IEEE RADIO FREQUENCY INTEGRATED CIRCUITS SYMPOSIUM (RFIC), IEEE, 4 June 2017 (2017-06-04), pages 244 - 247, XP033115793, DOI: 10.1109/RFIC.2017.7969063**

# Description

Domaine technique

La présente description concerne de façon générale le domaine des communications sans fil entre un lecteur et un dispositif de communication sans contact par modulation active de charge, en particulier entre un lecteur et un tel dispositif émulé en mode carte (ou CE pour « Card Emulation » en anglais). La présente description peut concerner en particulier le domaine des communications sans contact mises en œuvre en technologie NFC (« Near Field Communication » en anglais, ou communication en champ proche).

Technique antérieure

La communication en champ proche, ou NFC, est une technologie de connectivité sans fil permettant une communication sur une courte distance, par exemple de l'ordre d'une dizaine de centimètres, entre des dispositifs électroniques, comme par exemple une carte à puce sans contact et un lecteur, ou un dispositif CE (par exemple un téléphone mobile ou un objet connecté) et un lecteur.

Un dispositif de communication sans contact est un dispositif capable d'échanger des informations via une antenne avec un autre dispositif sans contact, par exemple un lecteur, selon un protocole de communication sans contact.

Un dispositif NFC, qui est un dispositif sans contact, est un dispositif compatible avec la technologie NFC. La technologie NFC est une plate-forme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC.

Un dispositif CE peut être utilisé pour échanger des informations avec un autre dispositif sans contact, par exemple un lecteur sans contact, en utilisant un protocole de communication sans contact utilisable dans la technologie NFC.

Lors d'une transmission d'informations entre un lecteur et un dispositif CE ou une carte NFC, le lecteur génère un champ électromagnétique par l'intermédiaire de son antenne qui est généralement, selon les normes classiquement utilisées, une onde sinusoïdale de fréquence égale à 13,56 MHz. Chacun des dispositifs NFC (lecteur et dispositif CE) transmet des données en utilisant un schéma de modulation, par exemple une modulation par déplacement d'amplitude ou ASK (« Amplitude Shift Keying » en anglais) ou OOK (« On Off Keying » en anglais).

Deux modes de fonctionnement sont possibles : un mode passif, qui correspond au mode utilisé par une carte NFC, ou un mode actif, qui correspond généralement au mode utilisé par un dispositif CE.

Dans le mode passif, également appelé PLM ou modulation de charge passive (« Passive Load Modulation » en anglais), seul le lecteur génère le champ électromagnétique et la carte est alors passive. L'antenne de la carte module le champ électromagnétique généré par le lecteur via une modification d'une charge connectée aux bornes de l'antenne de la carte, ce qui modifie l'impédance de sortie de l'antenne du lecteur en raison du couplage magnétique entre les deux antennes. Il en résulte un changement dans les amplitudes et/ou les phases des tensions et courants présents au niveau des antennes du lecteur et de la carte. Les informations sont ainsi transmises depuis la carte vers le lecteur par modulation de charge aux courants d'antenne du lecteur.

Dans le mode actif, également appelé ALM ou modulation de charge active (« Active Load Modulation » en anglais), le lecteur et le dispositif CE génèrent tous les deux un champ électromagnétique. Ce mode de fonctionnement est utilisé lorsque le dispositif CE est pourvu d'une source d'alimentation propre, par exemple une batterie.

Généralement, un dispositif CE comporte une antenne plus petite que celle d'une carte NFC, et c'est la raison pour laquelle une modulation de charge active est souvent utilisée dans un tel dispositif.

Lors d'une modulation de charge active, les champs électromagnétiques émis par le lecteur et le dispositif CE sont en phase l'un avec l'autre afin que la sensibilité de détection du dispositif ne soit pas réduite. Le dispositif CE peut notamment comporter une boucle à verrouillage de phase, ou PLL (« Phase Locked Loop » en anglais), et un circuit de transmission dont la sortie est couplée électriquement à l'antenne.

Le dispositif CE peut être configuré pour extraire un signal d'horloge à partir du champ électromagnétique émis par le lecteur et verrouiller la PLL sur les fronts montants ou descendants de ce signal. Cette extraction de signal d'horloge est par exemple réalisée par un comparateur différentiel couplé électriquement à la sortie du réseau passif de l'antenne du dispositif CE et comprenant par exemple un amplificateur à fort gain fonctionnant en saturation. Le signal de sortie de la PLL peut ensuite être utilisé pour mettre en œuvre une conversion numérique permettant de décoder le signal de modulation du lecteur.

Afin que le dispositif CE puisse répondre au lecteur, le signal de réponse du dispositif CE doit être en phase avec le champ électromagnétique émis par le lecteur. Le signal d'horloge extrait du champ électromagnétique émis par le lecteur doit donc suivre la phase et la fréquence du champ électromagnétique émis par le lecteur, et ne doit pas comporter de variations parasites.

Dans le cas d'une modulation de type OOK, le champ électromagnétique comprenant le signal de modulation alterne entre un état haut à un état bas. Du bruit peut toutefois être présent dans le champ électromagnétique reçu dans le dispositif CE lorsque le signal de modulation est à l'état bas, en raison du couplage existant entre le lecteur et le dispositif CE. Le signal d'horloge extrait à partir de ce champ peut dans ce cas comporter des variations parasites, ou instabilités, pouvant engendrer des décalages de phase et des erreurs dans le signal de sortie obtenu.

La demande de brevet US 2014/159870 A1 décrit un dispositif de communication sans contact par modulation de charge active, comprenant un circuit d'extraction de signal d'horloge configuré pour recevoir en entrée un signal de réception et délivrer en sortie un signal d'horloge ayant une première valeur lorsque le signal de réception est supérieur à un seuil du circuit d'extraction de signal d'horloge et ayant une deuxième valeur lorsque le signal de réception est inférieur au seuil.

Résumé de l'invention

Il existe un besoin de proposer une solution permettant de répondre aux problèmes rencontrés avec les solutions existantes.

Un mode de réalisation pallie tout ou partie des inconvénients des solutions connues et propose un dispositif de communication sans contact par modulation de charge active, comprenant au moins :

- un circuit d'extraction de signal d'horloge configuré pour recevoir en entrée un signal de réception et délivrer en sortie un signal d'horloge ayant une première valeur lorsque le signal de réception est supérieur à un seuil du circuit d'extraction de signal d'horloge et ayant une deuxième valeur lorsque le signal de réception est inférieur au seuil ;
- un circuit de modification de la valeur du seuil, configuré pour réduire la valeur du seuil lorsque la valeur du signal d'horloge est égale à la première valeur, ou pour augmenter la valeur du seuil lorsque la valeur du signal d'horloge est égale à la deuxième valeur.

Selon un mode de réalisation particulier, le seuil du circuit d'extraction de signal d'horloge a une valeur nulle.

Selon un mode de réalisation particulier, le circuit d'extraction de signal d'horloge et le circuit de modification de la valeur du seuil sont configurés tels que la valeur réduite du seuil soit compris entre 10 % et 20 % d'une amplitude minimale du signal de réception.

Selon un mode de réalisation particulier, le circuit d'extraction de signal d'horloge comporte une paire différentielle.

Selon un mode de réalisation particulier, le circuit d'extraction de signal d'horloge comporte en outre un premier miroir de courant couplé électriquement en parallèle à la paire différentielle.

Selon un mode de réalisation particulier, le circuit de modification de la valeur du seuil est configuré pour déséquilibrer une polarisation du premier miroir de courant du circuit d'extraction de signal d'horloge ou une polarisation de la paire différentielle et du premier miroir de courant du circuit d'extraction de signal d'horloge.

Selon un mode de réalisation particulier, le circuit d'extraction de signal d'horloge comporte en outre un amplificateur dont une entrée est couplée électriquement à l'une des branches du premier miroir de courant.

Selon un mode de réalisation particulier, le circuit de modification de la valeur du seuil comporte un deuxième miroir de courant couplé électriquement à l'une des branches du premier miroir de courant et des commutateurs configurés pour coupler électriquement le deuxième miroir de courant à un potentiel électrique d'alimentation du dispositif et à une source de courant, elle-même couplée à un potentiel électrique de référence du dispositif, selon la valeur du signal d'horloge.

Selon un mode de réalisation particulier, le circuit de modification de la valeur du seuil comporte un transistor et un commutateur configuré pour coupler électriquement le transistor du circuit de modification de la valeur du seuil en parallèle à un transistor de la paire différentielle lorsque la valeur du signal d'horloge est égale à la première valeur ou à la deuxième valeur.

Selon un mode de réalisation particulier, le dispositif comporte en outre une boucle à verrouillage de phase dont une entrée est couplée électriquement à une sortie du circuit d'extraction de signal d'horloge.

Selon un mode de réalisation particulier, le dispositif peut comporter en outre :

- un circuit de conversion numérique comprenant une entrée couplée électriquement à une sortie de la boucle à verrouillage de phase ;

- un circuit de transmission comprenant une sortie couplée électriquement à l'antenne et sur laquelle un signal de modulation en phase avec le signal de réception est destiné à être délivré, et comprenant une première entrée couplée électriquement à une sortie de la boucle à verrouillage de phase et une deuxième entrée couplée électriquement à une sortie du circuit de conversion numérique.

Brève description des dessins

Ces caractéristiques et avantages, ainsi que d'autres, seront exposés en détail dans la description suivante d'exemples de réalisation particuliers faite à titre non limitatif en relation avec les figures jointes parmi lesquelles :

- la figure 1 représente schématiquement un exemple de dispositif de communication sans contact par modulation de charge active communiquant avec un lecteur sans contact, selon un mode de réalisation particulier ;

- la figure 2 représente schématiquement le fonctionnement d'un circuit d'extraction de signal d'horloge et d'un circuit de modification de la valeur du seuil du circuit d'extraction dans un dispositif de communication sans contact par modulation de charge active, selon un mode de réalisation particulier ;

- la figure 3 représente schématiquement un premier exemple de réalisation d'un circuit d'extraction de signal d'horloge et d'un circuit de modification de la valeur du seuil du circuit d'extraction ;

- la figure 4 représente schématiquement un deuxième exemple de réalisation d'un circuit d'extraction de signal d'horloge et d'un circuit de modification de la valeur du seuil du circuit d'extraction ;

- la figure 5 représente schématiquement une variante du deuxième exemple de réalisation d'un circuit d'extraction de signal d'horloge et d'un circuit de modification de la valeur du seuil du circuit d'extraction.

Description des modes de réalisation

De mêmes éléments ont été désignés par de mêmes références dans les différentes figures. En particulier, les éléments structurels et/ou fonctionnels communs aux différents exemples de réalisation peuvent présenter les mêmes références et peuvent disposer de propriétés structurelles, dimensionnelles et matérielles identiques.

Par souci de clarté, seuls les étapes et éléments utiles à la compréhension des modes et exemples de réalisation décrits ont été représentés et sont détaillés. En particulier, la réalisation des différents éléments et circuits (circuit d'adaptation, boucle à verrouillage de phase, circuit de conversion numérique, circuit de transmission, etc.) du dispositif n'est pas détaillée. L'homme du métier sera à même de réaliser de manière détaillée les différentes fonctions du dispositif à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

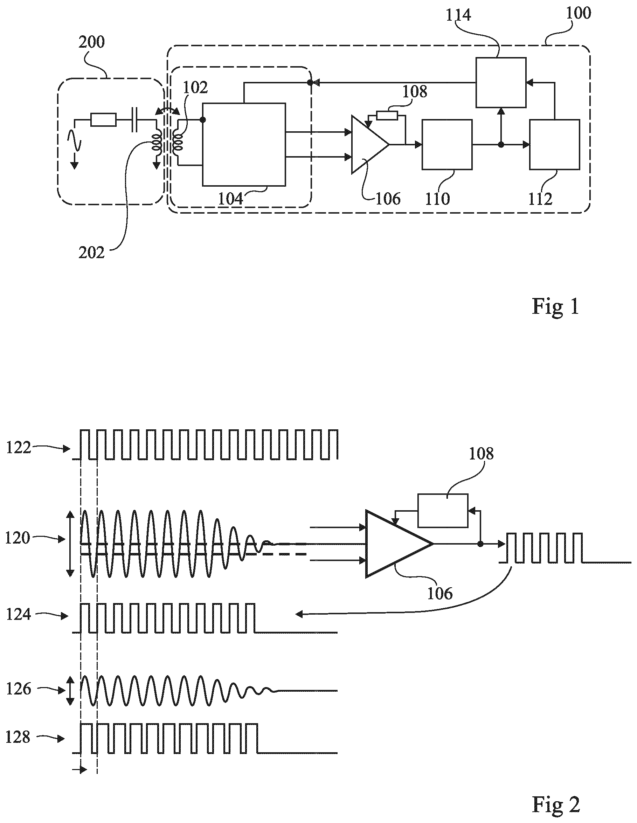

Un exemple d'un dispositif 100 de communication sans contact par modulation de charge active selon un mode de réalisation particulier est décrit ci-dessous en lien avec la figure 1.

Le dispositif 100 est de type NFC, c'est-à-dire est configuré pour utiliser un protocole de communication compatible avec la technologie NFC. Dans l'exemple décrit, le dispositif 100 correspond à un dispositif émulé en mode carte (CE). Sur la figure 1, le dispositif 100 est représenté lors d'une communication avec un lecteur 200 sans contact de type NFC.

Dans l'exemple de réalisation décrit, le dispositif 100 et le lecteur 200 communiquent l'un avec l'autre en utilisant une modulation de type OOK. Ainsi, le champ électromagnétique émis par le lecteur 200 et reçu par le dispositif 100 est amené à changer d'état, et à être soit à un état haut, transmis sous la forme d'un signal sinusoïdal par exemple de fréquence égale à 13,56 MHz (fréquence porteuse), soit à un état bas transmis sous la forme d'un signal nul.

Dans l'exemple de réalisation décrit, le dispositif 100 comporte une antenne 102 destinée à échanger des données avec une antenne 202 du lecteur 200 via l'émission de champs électromagnétiques par ces antennes 102, 202 et le couplage magnétique entre ces antennes 102, 202.

Dans la configuration particulière représentée sur la figure 1, le dispositif 100 comporte en outre un circuit d'adaptation 104 couplant électriquement l'antenne 102 aux autres éléments du dispositif 100. Le circuit 104 peut comporter des composants passifs, et peut servir notamment à adapter l'impédance de l'antenne 102 pour interfacer les signaux d'entrée et de sortie de l'antenne 102.

Le dispositif 100 comporte en outre un circuit d'extraction de signal d'horloge 106 configuré notamment pour recevoir en entrée un signal de réception issu d'un champ magnétique destiné à être reçu par l'antenne 102 et délivré en sortie du circuit d'adaptation 104. Le circuit 106 est également configuré pour délivrer en sortie un signal d'horloge ayant une première valeur, par exemple « 1 » ou état haut, lorsque le signal de réception est supérieur à une valeur d'un seuil du circuit 106 et ayant une deuxième valeur, par exemple « 0 » ou état bas, lorsque le signal de réception est inférieur à la valeur du seuil du circuit 106. Dans cet exemple, le circuit 106 forme donc un comparateur délivrant en sortie un signal d'horloge extrait à partir du signal de réception appliqué sur son entrée.

Dans l'exemple décrit, lorsque le signal reçu par l'antenne 102 correspond à un état haut transmis sous la forme d'un signal sinusoïdal, la valeur du signal d'horloge délivré en sortie du circuit 106 alterne entre les première et deuxième valeurs a une fréquence égale à la fréquence du signal sinusoïdal pendant toute la durée de cet état haut. Lorsque le signal reçu par l'antenne 102 correspond à un état bas transmis sous la forme d'un signal nul, la valeur du signal d'horloge délivré en sortie du circuit 106 est également nulle pendant toute la durée de cet état bas.

Le dispositif 100 comporte également un circuit 108 de modification de la valeur du seuil du circuit 106, configuré pour réduire la valeur du seuil lorsque la valeur du signal d'horloge délivré en sortie du circuit 106 est égale à la première valeur, ou pour augmenter la valeur du seuil lorsque la valeur du signal d'horloge est égale à la deuxième valeur. Sur l'exemple de la figure 1, une entrée du circuit 108 est couplée électriquement à la sortie du circuit 106, et une sortie du circuit 108 est couplée électriquement à une entrée du circuit 106.

Dans l'exemple de réalisation décrit, le dispositif 100 comporte en outre une boucle à verrouillage de phase 110, ou PLL, dont une entrée est couplée électriquement à la sortie du circuit 106. La PLL 110 est destinée à recevoir en entrée le signal d'horloge émis en sortie du circuit 106 et à délivrer en sortie un signal synchronisé et en phase avec le signal d'horloge reçu sur son entrée.

Le dispositif 100 peut comporter également un circuit de conversion numérique 112 comprenant une entrée couplée électriquement à une sortie de la PLL 110. Le circuit 112 est notamment destiné à décoder le signal transmis par le lecteur 200.

Dans l'exemple de réalisation décrit, le dispositif 100 comporte en outre un circuit de transmission 114 comprenant une sortie couplée électriquement à l'antenne 102 et sur laquelle un signal de modulation destiné à être émis par l'antenne 102 et en phase avec le signal de réception est destiné à être délivré. Le circuit 114 peut comporter en outre une première entrée couplée électriquement à une sortie de la PLL 110 et une deuxième entrée couplée électriquement à une sortie du circuit de conversion numérique 112.

Sur le schéma de la figure 1, seuls certains des éléments du dispositif 100 sont représentés. Le dispositif 100 comporte, en plus de ceux visibles sur la figure 1, d'autres circuits et éléments non décrits ici.

Le fonctionnement d'un exemple de réalisation du circuit 106 et du circuit 108 de modification de la valeur du seuil du circuit 106 est décrit ci-dessous en lien avec la figure 2.

La référence 120 désigne un premier exemple de signal de réception reçu en entrée du circuit 106. Ce premier exemple de signal de réception peut être obtenu lorsque les antennes du lecteur 200 et du dispositif 100 sont proches et fortement couplées l'une à l'autre, et a par exemple une amplitude crête à crête de l'ordre de 1 V.

La référence 122 désigne un signal carré représentant le signal d'horloge utilisé par le lecteur 200 pour l'émission de données. La phase et la fréquence du signal 120 sont donc similaires à celles du signal 122 ayant servi à l'obtention du champ électromagnétique non modulé émis par le lecteur 200.

Dans l'exemple de réalisation décrit en lien avec la figure 2, le circuit 106 est configuré tel que le signal d'horloge délivré en sortie du circuit 106 soit à l'état « 1 », ou état haut, lorsque le signal de réception est supérieur au seuil du circuit 106 (dont la valeur est égale à 0 V dans cet exemple), et soit à l'état « 0 », ou état bas, lorsque le signal de réception est inférieur au seuil du circuit 106. De plus, dans cet exemple de réalisation, le circuit 108 est configuré pour réduire la valeur du seuil du circuit 106 lorsque le signal d'horloge délivré en sortie du circuit 106 est à l'état « 1 ». Par exemple, la valeur réduite du seuil peut être comprise entre 10 % et 20 % de l'amplitude minimale du signal de réception (qui est par exemple de l'ordre de 0,2 V).

La référence 124 désigne le signal d'horloge obtenu en sortie du circuit 106 lorsque le signal de réception 120 est appliqué en entrée du circuit 106.

Dans cet exemple, du fait que la valeur du seuil du circuit 106 soit égale à 0 lorsque le signal d'horloge délivré par le circuit 106 est à l'état « 0 », le passage de l'état « 0 » à l'état « 1 » du signal d'horloge 124 se produit au même moment que le passage d'une valeur négative à une valeur positive du signal de réception 120. Par contre, du fait que la valeur du seuil du circuit 106 soit réduite lorsque le signal d'horloge délivré par le circuit 106 est à l'état « 1 », le passage de l'état « 1 » à l'état « 0 » du signal d'horloge 124 se produit avec un retard par rapport au passage d'une valeur positive à une valeur négative du signal de réception 120. Lorsque l'amplitude crête à crête du signal 120 est importante (comme c'est le cas ici), ce retard est très faible.

La référence 126 désigne un deuxième exemple de signal de réception reçu en entrée du circuit 106. Ce deuxième exemple de signal de réception peut être obtenu lorsque les antennes du lecteur 200 et du dispositif 100 sont éloignées et faiblement couplées l'une à l'autre, et a par exemple une amplitude crête à crête de l'ordre de 0,2 V.

La référence 128 désigne le signal d'horloge obtenu en sortie du circuit 106 lorsque le signal de réception 126 est appliqué en entrée du circuit 106.

Comme lorsque le signal de réception 126 est appliqué en entrée du circuit 106, le passage de l'état « 0 » à l'état « 1 » du signal 128 se produit au même moment que le passage d'une valeur négative à une valeur positive du signal 126, et le passage de l'état « 1 » à l'état « 0 » du signal 128 se produit avec un retard par rapport au passage d'une valeur positive à une valeur négative du signal 126. Du fait que l'amplitude crête à crête du signal 126 est faible, ce retard est plus important que dans le cas d'un signal de réception de forte amplitude crête à crête tel que le signal 120. Sur la figure 2, ce retard plus important se traduit par un état « 1 » du signal 128 de plus longue durée à chaque période du signal 128.

Que l'amplitude du signal de réception soit forte ou faible, l'abaissement du seuil du circuit 106 réalisé par le circuit 108 lorsque le signal d'horloge délivré par le circuit 106 est à l'état « 1 » permet d'éviter d'avoir, dans le signal d'horloge délivré par le circuit 106, l'apparition de variations ou commutations parasites, ou instabilités, correspondant par exemple à des auto-oscillations, lorsque l'information transmise par le signal de réception est à l'état bas, de telle variation parasites pouvant être engendrées en raison des glitchs, ou défaillances, générés par le bruit dans le signal de réception à ce moment-là en l'absence du circuit 108. Sur la figure 2, des phénomènes transitoires parasites correspondent à l'atténuation se produisant sur le signal de réception du fait que le passage de l'état haut à l'état bas de l'information transmise sur le signal de réception n'est pas instantané. Cet abaissement du seuil du circuit 106 réalisé par le circuit 108 lorsque le signal d'horloge est à l'état « 1 » permet d'éviter également des commutations parasites du signal d'horloge délivré par le circuit 106 lorsque du bruit est présent dans le signal de réception, par exemple lorsque sa valeur est proche de 0.

En outre, du fait que la valeur du seuil soit inchangée lorsque le signal d'horloge est à l'état « 0 », le passage de l'état « 0 » à l'état « 1 » du signal d'horloge obtenu en sortie du circuit 106 se produit sans retard par rapport au passage d'une valeur négative à une valeur positive du signal de réception. Ainsi, lorsque la PLL 110 est synchronisée par rapport aux fronts montants du signal appliqué sur son entrée (qui correspond au signal d'horloge délivré en sortie du circuit 106), cette absence de retard permet d'avoir au final un signal de réponse du dispositif 100 qui est en phase avec le champ électromagnétique émis par le lecteur 200. En outre, le retard obtenu dans le signal d'horloge de sortie du circuit 106 lors du passage d'une valeur positive à une valeur négative du signal de réception n'a pas d'impact lorsque la PLL 110 est synchronisée par rapport aux fronts montants du signal d'horloge.

Dans les exemples ci-dessus, le circuit 108 est configuré pour réduire la valeur du seuil du circuit 106 lorsque le signal d'horloge est à l'état « 1 ». Dans ce cas, lorsque le signal d'horloge est à l'état « 0 », le circuit 108 ne modifie pas la valeur du seuil du circuit 106 qui fonctionne à sa précision nominale, ce qui permet de ne pas dégrader le déphasage intrinsèque du dispositif 100. Dans cet exemple, seuls les fronts descendants du signal d'horloge sont affectés par un déphasage qui n'a pas d'incidence lorsque la PLL 110 est synchronisée par rapport aux fronts montants du signal d'horloge.

Selon un autre exemple, par exemple lorsque la PLL 110 est synchronisée par rapport aux fronts descendants du signal d'horloge, le circuit 108 peut être configuré pour augmenter la valeur du seuil du circuit 106 lorsque le signal d'horloge est à l'état « 0 ». Dans ce cas, lorsque le signal d'horloge est à l'état « 1 », le circuit 108 ne modifie pas la valeur du seuil du circuit 106 qui fonctionne à sa précision nominale (valeur du seuil par exemple égale à 0 V), ce qui permet de ne pas dégrader le déphasage intrinsèque du dispositif 100. Dans ce cas, seuls les fronts montants du signal d'horloge sont affectés par un déphasage qui n'a pas d'incidence lorsque la PLL 110 est synchronisée par rapport aux fronts descendants du signal d'horloge.

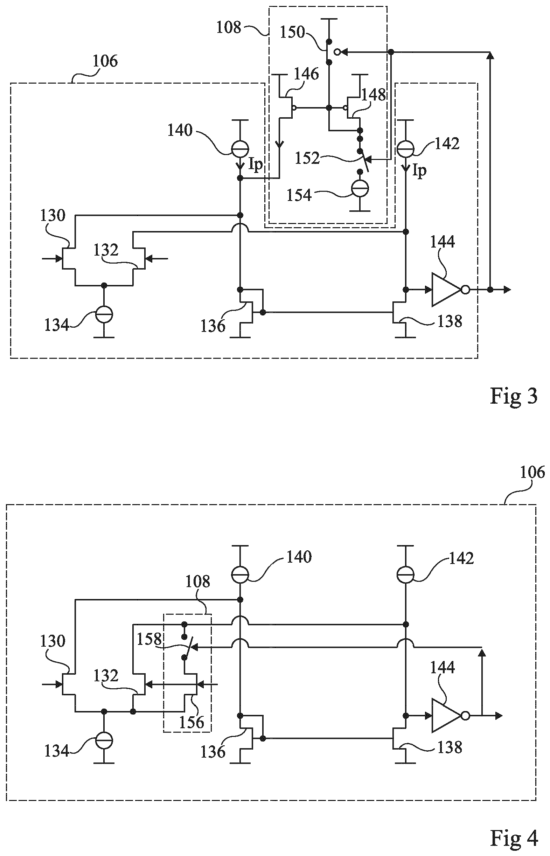

Un premier exemple de réalisation du circuit 106 et du circuit 108 est décrit ci-dessous en lien avec la figure 3.

Dans ce premier exemple, le circuit 106 comporte une paire différentielle formée de deux premiers transistors 130, 132 comprenant chacun une première de leurs électrodes de source / drain couplée électriquement à une première source de courant 134. Sur l'exemple de la figure 3, les premiers transistors 130, 132 sont par exemple des transistors NMOS et leur première électrode de source / drain correspond à l'électrode de source. Dans ce premier exemple, le signal de réception reçu en entrée du circuit 106 est appliqué sur la grille du transistor 130, et le signal opposé au signal de réception est appliqué sur la grille du transistor 132.

Le circuit 106 selon ce premier exemple comporte en outre un premier miroir de courant comprenant deux deuxièmes transistors 136, 138 comprenant chacun une première de leurs électrodes de source / drain couplée électriquement à une deuxième des électrodes de source / drain des deux premiers transistors 130, 132. Sur l'exemple de la figure 3, les deuxièmes transistors 136, 138 sont par exemple des transistors NMOS et leur première électrode de source / drain correspond à l'électrode de drain, et les deuxièmes des électrodes de source / drain des premiers transistors 130, 132 correspondent aux électrodes de drain. La première des électrodes de source / drain du deuxième transistor 136 est également couplée à la grille du deuxième transistor 136. Les premières des électrodes de source / drain des deuxièmes transistors 136, 138 sont également couplées électriquement à des deuxièmes sources de courant 140, 142 assurant la polarisation de ce premier miroir de courant et fournissant le courant nécessaire à la bonne polarisation de la paire différentielle formée par les deux premiers transistors 130, 132.

Le circuit 106 selon ce premier exemple comporte en outre un amplificateur 144 à fort gain dont l'entrée est couplée électriquement à la première électrode de source / drain du transistor 138, et dont la sortie forme la sortie du circuit 106 sur laquelle le signal d'horloge est destiné à être délivré. L'amplificateur 144 peut fonctionner en saturation afin que le signal d'horloge obtenu corresponde à un signal carré.

La paire différentielle formée par les deux premiers transistors 130, 132 permet de convertir la différence de potentiel appliquée sur les grilles des transistors 130, 132 en une différence de courant apparaissant à la jonction de l'entrée de l'amplificateur 144 avec l'une des branches du premier miroir de courant formé par les deux deuxièmes transistors 136, 138 (celle comprenant le transistor 138 sur la figure 3). L'utilisation du premier miroir de courant permet donc de délivrer en entrée de l'amplificateur 144 une tension dont la valeur est proportionnelle à cette différence de courant. Enfin, l'amplificateur 144, qui est à fort gain et qui fonctionne en saturation, permet de convertir la tension appliquée sur son entrée en un signal carré (signal d'horloge à l'état « 1 » lorsque la tension d'entrée de l'amplificateur 144 est positive, et à l'état « 0 » lorsque la tension d'entrée de l'amplificateur 144 est négative).

Le circuit 108 peut être configuré pour déséquilibrer une polarisation du premier miroir de courant formé par les deuxièmes transistors 136, 138.

Dans ce premier exemple, le circuit 108 comporte des troisièmes transistors 146, 148 formant un deuxième miroir de courant couplé électriquement à l'une des branches du premier miroir de courant formé par les deuxièmes transistors 136, 138. Sur l'exemple de la figure 3, les troisièmes transistors 146, 148 sont par exemple des transistors PMOS.

Le circuit 108 selon ce premier exemple comporte également un premier commutateur 150 configuré pour coupler ou non électriquement le potentiel électrique d'alimentation du dispositif 100 aux grilles des troisièmes transistors 146, 148 formant le deuxième miroir de courant, et un deuxième commutateur 152 configuré pour coupler ou non électriquement le deuxième miroir de courant au potentiel électrique de référence du dispositif 100 à travers une troisième source de courant 154.

Dans ce premier exemple, les circuits 106 et 108 peuvent être alimentés électriquement entre un premier potentiel électrique V1 (appliqué sur le premier commutateur 150, les troisièmes transistors 146, 148 et les deuxièmes sources de courant 140, 142) et un deuxième potentiel électrique V2 (appliqué sur la troisième source de courant 154, les deuxièmes transistors 136, 138 et la première source de courant 134). En choisissant ces potentiels électriques tels que V1 = -V2, la tension de mode commun, correspondant au point milieu de l'amplificateur, est nulle. Plus généralement, la tension de mode commun Vmc s'exprime par l'équation :

[Math 1]

$$Vmc = (V1 + V2)/2$$

Dans l'exemple représenté sur la figure 3, le premier commutateur 150 est à l'état ouvert lorsque le signal d'horloge délivré par le circuit 106 et appliqué sur son entrée de commande est à l'état « 1 », et est à l'état fermé lorsque le signal d'horloge est à l'état « 0 ». Par contre, le deuxième commutateur 152 est à l'état ouvert lorsque le signal d'horloge appliqué sur son entrée de commande est à l'état « 0 », et est à l'état fermé lorsque le signal d'horloge est à l'état « 1 ».

Ainsi, lorsque le signal d'horloge est à l'état « 0 », le circuit 108 n'a pas d'impact sur la valeur du seuil du circuit 106 (le circuit 106 fonctionne comme si le circuit 108 était absent). Aucun courant ne passe par le miroir de courant du circuit 108 représenté sur la figure 3.

Lorsque le signal d'horloge est à l'état « 1 », la connexion du circuit 108 à l'une des branches du premier miroir de courant formé par les deuxièmes transistors 136, 138 modifie la valeur du seuil du circuit 106. En effet, lorsque le premier commutateur 150 est à l'état ouvert et que le deuxième commutateur 152 est à l'état fermé, le couplage électrique du circuit 108 à l'une des branches du premier miroir de courant ajoute un courant supplémentaire dans cette branche par rapport à l'autre branche du premier miroir de courant. Cette dissymétrie de courant dans les branches du premier miroir de courant se retrouve à la jonction entre l'entrée de l'amplificateur 144 et l'une des branches de la paire différentielle, ce qui engendre un offset, ou décalage, de la valeur du seuil du circuit 106.

La tension à l'entrée de l'amplificateur 144 est proportionnelle à la différence de courants (i140 - i130) - (i142 - i132), avec i130, i140, i132 et i142 correspondant aux courants circulant dans les composants 130, 140, 132 et 142 respectivement. Ainsi, la modification de la tension de seuil du circuit 106 est obtenue grâce à la différence de courant entre la source formée par la source de courant 140 + circuit 108 et la source 142.

Lorsque le circuit 108 est inactif (premier commutateur 150 à l'état fermé), le courant de polarisation circulant dans le drain du deuxième transistor 136 est égal au courant fourni par la source de courant 140 auquel est soustrait le courant de polarisation circulant dans le transistor 130, et qui est alors égal au courant fourni par la source de courant 142 auquel est soustrait le courant de polarisation circulant dans le transistor 132. La tension de seuil du circuit 106 n'est alors pas modifiée.

Lorsque le circuit 108 est actif (premier commutateur 150 à l'état ouvert), le courant de polarisation circulant dans le drain du deuxième transistor 136 est égal au courant fourni par la source de courant 140 auquel est soustrait le courant de polarisation circulant dans le transistor 130, et auquel vient s'ajouter le courant fourni par le circuit 108. Le courant fourni par la source de courant 140 n'est dans ce cas plus égal à celui fourni par la source de courant 142 auquel est soustrait le courant de polarisation circulant dans le transistor 132, ce qui engendre la modification de la tension de seuil du circuit 106.

En variante, le circuit 108 selon ce premier exemple peut être configuré pour augmenter la valeur du seuil du circuit 106 lorsque le signal d'horloge est à l'état « 0 », et pour ne pas modifier la valeur du seuil du circuit 106 lorsque le signal d'horloge est à l'état « 1 ». Le circuit 108 selon cette variante comporte par exemple les mêmes éléments que ceux représentés sur la figure 3, à l'exception du premier commutateur 150 qui est dans ce cas configuré pour être à l'état fermé lorsque le signal d'horloge appliqué sur son entrée de commande est à l'état « 1 », et être à l'état ouvert lorsque le signal d'horloge est à l'état « 0 ». Dans cette variante, le deuxième commutateur 152 est également configuré tel qu'il soit à l'état fermé lorsque le signal d'horloge appliqué sur son entrée de commande est à l'état « 0 », et à l'état ouvert lorsque le signal d'horloge est à l'état « 1 ». En outre, dans cette variante, par rapport à l'exemple précédemment décrit en lien avec la figure 3, la sortie du circuit 108 n'est pas couplée électriquement à la branche du premier miroir de courant formée par le transistor 136 mais est couplée électriquement à la branche de sortie du premier miroir de courant formée par le transistor 138, et donc à l'entrée de l'amplificateur 144.

Un deuxième exemple de réalisation du circuit 106 et du circuit 108 est décrit ci-dessous en lien avec la figure 4.

Dans ce deuxième exemple, le circuit 106 comporte les mêmes composants que ceux du circuit 106 du premier exemple de réalisation précédemment décrit.

Le circuit 108 selon ce deuxième exemple comporte un quatrième transistor 156 et un commutateur 158 configuré pour coupler ou non électriquement le quatrième transistor 156 en parallèle du transistor 132 du circuit 106. Plus particulièrement, dans cet exemple, le commutateur 158 est configuré pour être à l'état ouvert lorsque le signal d'horloge est à l'état « 0 », et être à l'état fermé lorsque le signal d'horloge est à l'état « 1 ».

Dans ce deuxième exemple, un déséquilibrage de l'une des branches de la paire différentielle est réalisé par la connexion du quatrième transistor 156 en parallèle du transistor 132, augmentant la transconductance du transistor vu au niveau de cette branche de la paire différentielle, et modifiant la valeur du seuil du circuit 106.

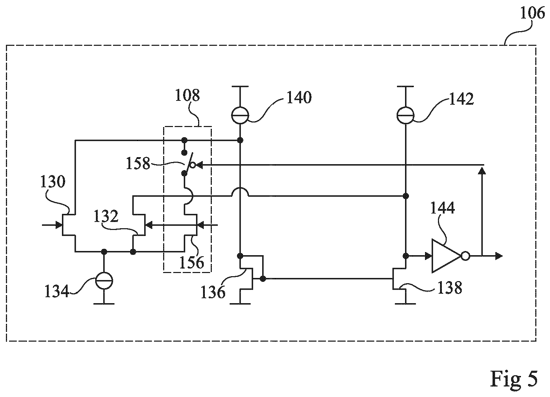

En variante, le circuit 108 selon ce deuxième exemple peut être configuré pour augmenter la valeur du seuil du circuit 106 lorsque le signal d'horloge est à l'état « 0 », et pour ne pas modifier la valeur du seuil du circuit 106 lorsque le signal d'horloge est à l'état « 1 ». Le circuit 108 selon cette variante comporte par exemple les mêmes éléments que ceux représentés sur la figure 4, à l'exception du quatrième transistor 156 et du commutateur 158 qui est configuré pour coupler ou non électriquement le quatrième transistor 156 en parallèle du transistor 130 du circuit 106, le commutateur 158 étant configuré pour être à l'état fermé lorsque le signal d'horloge appliqué sur son entrée de commande est à l'état « 0 », et être à l'état ouvert lorsque le signal d'horloge est à l'état « 1 ». Une telle variante des circuits 106 et 108 est représentée sur la figure 5.

Dans l'exemple de circuit 106 décrit ci-dessus en lien avec les figures 3 à 5, il est possible de modifier la valeur du seuil du circuit 106 en modifiant les valeurs des courants délivrés par chacune des sources de courant 140, 142. Ainsi, lorsque les courants délivrés par les sources 140, 142 sont égaux, la valeur du seuil nominal (c'est-à-dire sans l'intervention du circuit 108) du circuit 106 peut être égale à 0. Lorsque le courant délivré par la source 140 est supérieur à celui délivré par la source 142, la valeur du seuil nominal du circuit 106 peut être inférieure à 0. Lorsque le courant délivré par la source 140 est inférieur à celui délivré par la source 142, la valeur du seuil nominal du circuit 106 peut être supérieure à 0.

Dans les différents exemples précédemment décrits, le circuit 108 et le circuit 106 peuvent être vus comme formant ensemble un comparateur à seuil dynamique, dans lequel une variation du seuil est présente uniquement lorsque le signal de sortie du comparateur est à l'état haut ou bas.

Dans les exemples des figures 3 et 4 précédemment décrits, chacune des électrodes de source / drain d'un des transistors peut correspondre à l'électrode de source ou à l'électrode de drain de ce transistor, en fonction du type, ou de la conductivité, n ou p du transistor.

En outre, un ou des composants différents du circuit 106 et/ou du circuit 108 décrits ci-dessus peuvent servir à remplir des fonctions analogues à celles décrites.

Dans les différents exemples de réalisation précédemment décrits, chacun des commutateurs 150, 152, 158 peut correspondre à un transistor MOS.

Dans les différents exemples de réalisation, l'état « 1 » d'un signal peut correspondre à une amplitude égale à la tension d'alimentation du dispositif 100, et l'état « 0 » d'un signal peut correspondre à une amplitude égale au potentiel de référence du dispositif 100, par exemple la masse dont le potentiel électrique est nul.

Dans la description ci-dessus, le dispositif 100 correspond à un dispositif de communication sans contact par modulation de charge active qui est, lors d'une communication avec un lecteur, émulé en mode carte. Le dispositif 100 peut être doté de fonctionnalités autres que celles décrites ci-dessus. Le dispositif 100 peut correspondre par exemple à un téléphone mobile ou un objet connecté tel qu'une montre.

Divers exemples de réalisation et variantes ont été décrits. La personne du métier comprendra que certaines caractéristiques de ces divers exemples de réalisation et variantes pourraient être combinées, et d'autres variantes apparaîtront à la personne du métier.

Enfin, la mise en œuvre pratique des exemples de réalisation et variantes décrits est à la portée de la personne du métier à partir des indications fonctionnelles données ci-dessus.

**Revendications**

1. Dispositif (100) de communication sans contact par modulation de charge active, comprenant au moins :

   - un circuit d'extraction de signal d'horloge (106) configuré pour recevoir en entrée un signal de réception et délivrer en sortie un signal d'horloge ayant une première valeur lorsque le signal de réception est supérieur à un seuil du circuit d'extraction de signal d'horloge (106) et ayant une deuxième valeur lorsque le signal de réception est inférieur au seuil ;
   - un circuit (108) de modification de la valeur du seuil, configuré pour réduire la valeur du seuil lorsque la valeur du signal d'horloge est égale à la première valeur, ou pour augmenter la valeur du seuil lorsque la valeur du signal d'horloge est égale à la deuxième valeur.

2. Dispositif (100) selon l'une des revendications précédentes, dans lequel le seuil du circuit d'extraction de signal d'horloge (106) a une valeur nulle.

3. Dispositif (100) selon l'une des revendications précédentes, dans lequel le circuit d'extraction de signal d'horloge (106) et le circuit (108) de modification de la valeur du seuil sont configurés tels que la valeur réduite du seuil soit comprise entre 10 % et 20 % d'une amplitude minimale du signal de réception.

4. Dispositif (100) selon l'une des revendications précédentes, dans lequel le circuit d'extraction de signal d'horloge (106) comporte une paire différentielle (130, 132).

5. Dispositif (100) selon la revendication 4, dans lequel le circuit d'extraction de signal d'horloge (106) comporte en outre un premier miroir de courant (136, 138) couplé électriquement en parallèle à la paire différentielle (130, 132).

6. Dispositif (100) selon la revendication 5, dans lequel le circuit (108) de modification de la valeur du seuil est configuré pour déséquilibrer une polarisation du premier miroir de courant (136, 138) du circuit d'extraction de signal d'horloge (106) ou une polarisation de la paire différentielle (130, 132) et du premier miroir de courant (136, 138) du circuit d'extraction de signal d'horloge (106).

7. Dispositif (100) selon l'une des revendication 5 ou 6, dans lequel le circuit d'extraction de signal d'horloge (106) comporte en outre un amplificateur (144) dont une entrée est couplée électriquement à l'une des branches du premier miroir de courant (136, 138).

8. Dispositif (100) selon l'une des revendications 4 à 7, dans lequel le circuit (108) de modification de la valeur du seuil comporte un deuxième miroir de courant (146, 148) couplé électriquement à l'une des branches du premier miroir de courant (136, 138) et des commutateurs (150, 152) configurés pour coupler électriquement le deuxième miroir de courant (146, 148) à un potentiel électrique d'alimentation du dispositif (100) et à une source de courant, elle-même couplée à un potentiel électrique de référence du dispositif (100), selon la valeur du signal d'horloge.

9. Dispositif (100) selon l'une des revendications 4 à 7, dans lequel le circuit (108) de modification de la valeur du seuil comporte un transistor (156) et un commutateur (158) configuré pour coupler électriquement le transistor (156) du circuit (108) de modification de la valeur du seuil en parallèle à un transistor (130) de la paire différentielle (130, 132) lorsque la valeur du signal d'horloge est égale à la première valeur ou à la deuxième valeur.

10. Dispositif (100) selon l'une des revendications précédentes, comportant en outre une boucle à verrouillage de phase (110) dont une entrée est couplée électriquement à une sortie du circuit d'extraction de signal d'horloge (106).

11. Dispositif (100) selon la revendication 10, comportant en outre :

    - un circuit de conversion numérique (112) comprenant une entrée couplée électriquement à une sortie de la boucle à verrouillage de phase (110) ;
    - un circuit de transmission (114) comprenant une sortie couplée électriquement à l'antenne (102) et sur laquelle un signal de modulation en phase avec le signal de réception est destiné à être délivré, et comprenant une première entrée couplée électriquement à une sortie de la boucle à verrouillage de phase (110) et une deuxième entrée couplée électriquement à une sortie du circuit de conversion numérique (112).

**Patentansprüche**

1. Eine Einrichtung (100) zur kontaktlosen Kommunikation durch aktive Lastmodulation, die mindestens aufweist:

    - eine Taktsignal-Extraktionsschaltung (106), die so konfiguriert ist, dass sie als Eingabe ein Empfangssignal empfängt und ein Taktsignal mit einem ersten Wert ausgibt, wenn das Empfangssignal größer als ein Schwellenwert der Taktsignal-Extraktionsschaltung (106) ist, und mit einem zweiten Wert, wenn das Empfangssignal kleiner als der Schwellenwert ist;
    - eine Schaltung (108) zum Modifizieren des Wertes des Schwellenwertes, die so konfiguriert ist, dass sie den Wert des Schwellenwertes verringert, wenn der Wert des Taktsignals gleich dem ersten Wert ist, oder den Wert des Schwellenwertes erhöht, wenn der Wert des Taktsignals gleich dem zweiten Wert ist.

2. Einrichtung (100) nach Anspruch 1, wobei der Schwellenwert der Taktsignalextraktionsschaltung (106) einen Wert von Null hat.

3. Einrichtung (100) nach einem der vorstehenden Ansprüche, wobei die Taktsignalextraktionsschaltung (106) und die Schaltung (108) zum Modifizieren des Schwellenwerts so konfiguriert sind, dass der verringerte Wert des Schwellenwerts im Bereich von 10 % bis 20 % einer minimalen Amplitude des Empfangssignals liegt.

4. Einrichtung (100) nach einem der vorstehenden Ansprüche, wobei die Taktsignalextraktionsschaltung (106) ein Differentialpaar (130, 132) aufweist.

5.  Einrichtung (100) nach Anspruch 4, wobei die Taktsignalextraktionsschaltung (106) ferner einen ersten Stromspiegel (136, 138) aufweist, der elektrisch parallel zu dem Differentialpaar (130, 132) geschaltet ist.

6.  Einrichtung (100) nach Anspruch 5, wobei die Schaltung (108) zum Modifizieren des Schwellenwerts so konfiguriert ist, dass sie eine Vorspannung des ersten Stromspiegels (136, 138) der Taktsignalextraktionsschaltung (106) oder eine Vorspannung des Differentialpaars (130, 132) und des ersten Stromspiegels (136, 138) der Taktsignal-Extraktionsschaltung (106) aus dem Gleichgewicht zu bringen.

7.  Einrichtung (100) nach einem der Ansprüche 5 oder 6, wobei die Taktsignal-Extraktionsschaltung (106) ferner einen Verstärker (144) aufweist, dessen Eingang elektrisch mit einem der Zweige des ersten Stromspiegels (136, 138) gekoppelt ist.

8.  Einrichtung (100) nach einem der Ansprüche 4 bis 7, wobei die Schaltung (108) zum Modifizieren des Schwellenwerts einen zweiten Stromspiegel (146, 148) aufweist, der elektrisch mit einem der Zweige des ersten Stromspiegels (136, 138) und Schalter (150, 152) aufweist, die so konfiguriert sind, dass sie den zweiten Stromspiegel (146, 148) entsprechend dem Wert des Taktsignals elektrisch mit einem Stromversorgungspotential der Einrichtung (100) und mit einer Stromquelle koppeln, die ihrerseits mit einem elektrischen Referenzpotential der Einrichtung (100) gekoppelt ist.

9.  Einrichtung (100) gemäß einem der Ansprüche 4 bis 7, wobei die Schaltung (108) zum Modifizieren des Schwellenwerts einen Transistor (156) und einen Schalter (158) aufweist, der so konfiguriert ist, dass er den Transistor (156) der Schaltung (108) zum Modifizieren des Schwellenwerts parallel zu einem Transistor (130) des Differentialpaars (130, 132) zu koppeln, wenn der Wert des Taktsignals gleich dem ersten Wert oder dem zweiten Wert ist.

10. Einrichtung (100) nach einem der vorstehenden Ansprüche, die ferner eine Phasenregelschleife (110) aufweist, deren Eingang elektrisch mit einem Ausgang der Taktsignal-Extraktionsschaltung (106) gekoppelt ist.

11. Einrichtung (100) nach Anspruch 10, die ferner aufweist:

    - eine digitale Umwandlungsschaltung (112) mit einem Eingang, der elektrisch mit einem Ausgang der Phasenregelschleife (110) gekoppelt ist;
    - eine Übertragungsschaltung (114) mit einem elektrisch mit der Antenne (102) gekoppelten Ausgang, an den ein mit dem Empfangssignal phasengleiches Modulationssignal geliefert werden soll, und mit einem ersten elektrisch mit einem Ausgang der Phasenregelschleife (110) gekoppelten Eingang und einem zweiten elektrisch mit einem Ausgang der Digitalwandlerschaltung (112) gekoppelten Eingang.

**Claims**

1.  Device (100) of contactless communication by active load modulation, comprising at least:

    - a clock signal extraction circuit (106) configured to receive as an input a reception signal and to output a clock signal having a first value when the reception signal is greater than a threshold of the clock signal extraction circuit (106) and having a second value when the reception signal is smaller than the threshold;
    - a circuit (108) for modifying the value of the threshold, configured to decrease the value of the threshold when the value of the clock signal is equal to the first value, or to increase the value of the threshold when the value of the clock signal is equal to the second value.

2.  Device (100) according to claim 1, wherein the threshold of the clock signal extraction circuit (106) has a zero value.

3.  Device (100) according to any of the foregoing claims, wherein the clock signal extraction circuit (106) and the circuit (108) for modifying the value of the threshold are configured so that the decreased value of the threshold is in the range from 10% to 20% of a minimum amplitude of the reception signal.

4.  Device (100) according to any of the foregoing claims, wherein the clock signal extraction circuit (106) comprises a differential pair (130, 132).

5.  Device (100) according to claim 4, wherein the clock signal extraction circuit (106) further comprises a first current mirror (136, 138) electrically coupled in parallel with the differential pair (130, 132).

6.  Device (100) according to claim 5, wherein the circuit (108) for modifying the value of the threshold is configured to unbalance a biasing of the first current mirror (136, 138) of the clock signal extraction circuit (106) or a biasing of the differential pair (130, 132) and of the first current mirror (136, 138) of the clock signal extraction circuit (106).

7. Device (100) according to one of claims 5 or 6, wherein the clock signal extraction circuit (106) further comprises an amplifier (144) having an input electrically coupled to one of the branches of the first current mirror (136, 138).

8. Device (100) according to one of claims 4 to 7, wherein the circuit (108) for modifying the value of the threshold comprises a second current mirror (146, 148) electrically coupled to one of the branches of the first current mirror (136, 138) and switches (150, 152) configured to electrically couple the second current mirror (146, 148) to an electric power supply potential of the device (100) and to a current source, itself coupled to a reference electric potential of the device (100), according to the value of the clock signal.

9. Device (100) according to one of claims 4 to 7, wherein the circuit (108) for modifying the value of the threshold comprises a transistor (156) and a switch (158) configured to electrically couple the transistor (156) of the circuit (108) for modifying the value of the threshold in parallel with a transistor (130) of the differential pair (130, 132) when the value of the clock signal is equal to the first value or to the second value.

10. Device (100) according to any of the foregoing claims, further comprising a phase-locked loop (110) having an input electrically coupled to an output of the clock signal extraction circuit (106).

11. Device (100) according to claim 10, further comprising:

> - a digital conversion circuit (112) comprising an input electrically coupled to an output of the phase-locked loop (110);
> - a transmission circuit (114) comprising an output electrically coupled to the antenna (102) and on which a modulation signal in phase with the reception signal is intended to be delivered, and comprising a first input electrically coupled to an output of the phase-locked loop (110) and a second input electrically coupled to an output of the digital conversion circuit (112).

Fig 1

Fig 2

Fig 3

Fig 4

EP 4 529 028 B1

Fig 5

14

## RÉFÉRENCES CITÉES DANS LA DESCRIPTION

**Documents brevets cités dans la description**

- US 2014159870 A1